# EUROPÄISCHE PATENTSCHRIFT

(11) **EP 4 587 847 B1**
(45) Veröffentlichungstag und Bekanntmachung des Hinweises auf die Patenterteilung: **03.06.2026**
(21) Anmeldenummer: 23804942.3
(22) Anmeldetag: 31.10.2023
(51) Int. Cl.: G01R 15/14, G01R 15/16, G01R 15/20, G01R 11/04, G01R 21/06, G01R 22/06

(54) **BESTIMMUNG EINES ELEKTRISCHEN ENERGIEFLUSSES**
DETERMINING AN ELECTRICAL ENERGY FLOW
DÉTERMINATION D'UN FLUX D'ÉNERGIE ÉLECTRIQUE

(30) Priorität: 04.11.2022 EP 22205599; 26.04.2023 EP 23169950
(43) Veröffentlichungstag der Anmeldung: 23.07.2025
(73) Patentinhaber: Siemens Aktiengesellschaft, 80333 München (DE)
(72) Erfinder: GRÖGER, Andreas, 81735 München (DE); KRIEGEL, Kai, 81739 München (DE); RAAB, Oliver, 94496 Ortenburg (DE); SANTOS WILKE, Hans, 85599 Parsdorf (DE)
(74) Vertreter: Siemens Patent Attorneys
(86) Internationale Anmeldenummer: PCT/EP2023/080357
(87) Internationale Veröffentlichungsnummer: WO 2024/094694

(56) Entgegenhaltungen:
- EP-A1- 3 321 699
- US-A1- 2018 136 257
- US-A1- 2019 346 502
- US-A1- 2022 082 590

## Beschreibung

Die Erfindung betrifft ein Verfahren zur Bestimmung eines elektrischen Leistungs- und/oder Energieflusses durch einen elektrischen Leiter, bei der eine gleichzeitige Bestimmung der beiden physikalischen Größen Strom und Spannung an einem Ort erfolgt und daraus die elektrische Leistung und/oder elektrische Energie ermittelt wird. Des Weiteren betrifft die Erfindung eine Vorrichtung zur Bestimmung eines elektrischen Leistungs- und/oder Energieflusses.

### Stand der Technik:

Die exakte Bestimmung von elektrischen Energieflüssen und Energieverbräuchen ist eine wichtige Aufgabe für unterschiedliche Anwendungsfelder wie z.B. der industriellen Automatisierung, der Gebäudetechnik aber auch in großflächigen elektrischen Verteilernetzen. Insbesondere auch im Zuge der voranschreitenden Umstellung auf erneuerbare Energien und der Dezentralisierung der Energieerzeugung wird es in Zukunft von entscheidender Bedeutung sein, elektrische Energieflüsse örtlich aufgelöst abbilden zu können.

Um elektrische Energieflüsse zu bestimmen, ist eine gleichzeitige Messung der beiden physikalischen Größen Strom und Spannung am selben Ort, also am selben Leitungsabschnitt durchzuführen. Zur Durchführung der Strom- und Spannungsmessungen stehen unterschiedliche Messverfahren zur Verfügung. Bisher werden Energiemessungen bevorzugt mit Hilfe eines Gerätes durchgeführt, welches in eine bestehende Stromverbindung, beispielsweise eine elektrische Leitung oder ein Stromkabel, eingefügt wird.

Dies ist notwendig, weil bisherige bewährte Spannungsmessungen in den meisten Fällen mittels berührender Verfahren vorgenommen werden, beispielsweise mit einem Analog-Digital-Konverter. Berührendes Verfahren heißt, dass ein physischer Kontakt zum Messobjekt hergestellt werden muss, um eine direkte Messung im Stromkreis vorzunehmen. Hierzu muss also eine Messvorrichtung entweder fest integriert sein oder alternativ würde die Isolation der zu messenden Stromleitung unterbrochen, d.h. beschädigt werden müssen. Dieser notwendige direkte physische Kontakt zur stromführenden Leitung hat insbesondere bei bereits bestehenden Anlagen ("Brownfield") den Nachteil, dass diese zur Vornahme einer Messung oder zur Installation zwischenzeitlich vom Netz getrennt werden müssen und im späteren Betrieb strenge Sicherheitsanforderungen eingehalten werden müssen, was die elektrische Sicherheit betrifft. Auch für die Datenübertragung muss eine galvanische Trennung realisiert werden.

Zwar stehen für die Messung eines Stromflusses auch berührungslose Methoden, wie z.B. Hall-Sensoren oder Rogowski-Spulen, zur Verfügung, eine Kombination von Strom- und Spannungsmessung zur Bestimmung einer elektrischen Leistung oder Energie bringt jedoch bisher stets die Herausforderung der berührenden Spannungsmessung mit sich.

Aus dem Stand der Technik, beispielsweise aus der DE 10 2010 035 381 A1 und der DE 10 2008 052 477 A1 ist ein Verfahren zur berührungslosen Spannungsmessung bekannt: Das Prinzip des MEMS-Voltmeters, auch bezeichnet als mikromechanische Feldmühle, beruht auf einer Messung der zeitlichen Veränderung einer elektrischen Kapazität mittels eines mikroelektromechanischen Systems. Die zeitliche Veränderung der Kapazität wird mechanisch mit einem elektrischen, elektrostatischen oder thermischen Aktor herbeigeführt. Um die Veränderung der Kapazität zu messen, wird ein Verschiebungsstrom durch einen Strom-Spannungs-Wandler erfasst und hierdurch ein Messsignal generiert. Der Einfluss der zu messenden elektrischen Spannung auf das Messergebnis wird dadurch eliminiert, dass die Spannung konstante Anteile enthält und der Strom-Spannungs-Wandler während der Schaltflanken der Spannung abgetastet wird. So kann eine Impulsantwort auf Spannungsänderungen der zu messenden Spannung, die auch auf den Messkondensator wirken, ausgeblendet werden. Es wird die Eigenschaft des kapazitiven Messprinzips genutzt, dass ein Signal nur detektiert werden kann, wenn sich am Kondensator Ladungen verschieben, die einen Verschiebungsstrom I(t) initiieren. Hierfür gilt die Gleichung I(t) = dC/dt·U + dU/dt·C, wobei C die Kapazität des Kondensators ist und U die am Kondensator anliegende Spannung. Die Kapazität des Kondensators, beziehungsweise die Kapazität zwischen einem Messobjekt, beispielsweise einem stromführenden Leiter, und dem Sensor, also dem MEMS-Voltmeter, kann durch Änderung der Fläche der Kondensatorplatten, insbesondere durch Einschieben von Blenden in den Kondensatorspalt, durch Änderung des Abstandes der Kondensatorplatten oder durch Änderung der relativen Dielektrizitätskonstante des zwischen den Platten befindlichen Mediums geändert werden, gemäß DE 10 2010 035 381 A1 und DE 10 2008 052 477 A1.

US 2022/082590 A1 beschreibt eine kontaktlose Vorrichtung zur Messung elektrischer Parameter mit radial montierten Sensoren.

Ausgehend vom zuvor beschriebenen Stand der Technik, liegt der Erfindung die Aufgabe zugrunde, ein Verfahren und eine Vorrichtung zur berührungslosen Bestimmung eines elektrischen Leistungs- und/oder Energieflusses anzugeben.

Diese Aufgabe wird durch die Merkmale des unabhängigen Patentanspruchs 1, sowie durch die Merkmale des unabhängigen Patentanspruchs 4 gelöst. Vorteilhafte Ausgestaltungen der Erfindung sind Gegenstand der Unteransprüche.

Das erfindungsgemäße Verfahren zur berührungslosen elektrischen Leistungs- und/oder Energiebestimmung umfasst einen Messsignalverarbeitungsschritt, in dem aus gemessenen Strom- und Spannungswerten die elektrische Leistung und/oder Energie ermittelt wird. Dabei wird zunächst eine erfindungsgemäße Vorrichtung mit einem zu vermessenden elektrischen Leiter galvanisch getrennt angeordnet, eine Strommessung an dem elektrischen Leiter vorgenommen, indem das vom stromdurchflossenen Leiter ausgehende magnetische Feld mittels eines ersten Sensors bestimmt wird, zeitgleich eine Spannungsmessung an dem elektrischen Leiter vorgenommen, indem das vom stromdurchflossenen Leiter ausgehende elektrische Feld mittels eines zweiten Sensors bestimmt wird, und diese beiden Messsignale entweder analog mittels eines elektrischen Schaltkreises und / oder in einem digitalen Datenverarbeitungsschritt miteinander verrechnet. Unter "galvanisch getrennt" ist zu verstehen, dass es zwar eine Potentialauswirkung als elektrisches Feld und magnetisches Feld auf Grund des Stromfluss gibt, aber es liegt eine elektrische Isolation vor, so dass kein Strom zwischen dem zu vermessenden Leiter und der Vorrichtung fließt. Die Anordnung erfolgt dabei zweckdienlicherweise mittels der Abstandshalter, z.B. über eine mechanische Montagevorrichtung oder über eine messtechnisch festgelegte Positionierung, insbesondere auch ohne bauliche Verbindung zum zu messenden Leiter. Diese birgt unter anderem den Vorteil, dass somit bestehende Systeme, z.B. Brownfield-Systeme, ohne baulichen Eingriff nachgerüstet werden können.

Dabei erfolgt in dem erfindungsgemäßen Verfahren zur berührungslosen elektrischen Leistungs- und/oder Energiebestimmung die Spannungsmessung mittels eines MEMS-Voltmeters.

In einer besonders vorteilhaften Variante des Verfahrens wird die Vorrichtung mittels Abstandshaltern in einem vorgebbaren Messabstand relativ zum zu vermessenden elektrischen Leiter galvanisch getrennt angeordnet. Damit kann insbesondere ein Mindestabstand von 100 µm und ein Maximalabstand, der in Relation steht zur zu bestimmenden Spannungsniveaus und weiteren Störquellen steht eingestellt werden. Hierzu sind Abstandshalter vorgesehen, welche insbesondere auch als Montagevorrichtung, Kabelführung, Kabelzange ausgeführt sein können oder besonders vorteilhaft bereits Teile des Stromsensors, insbesondere die Magnetfeldkonzentratoren umfassen. Alternativ umfassen die Abstandshalter Abstandssensoren, wodurch eine Fixierung des Messabstands ermöglich wird.

In einer weiteren Variante des Verfahrens ist mindestens ein analoger Messsignalvorverarbeitungsschritt auf Ebene der Sensoren umfasst, bei dem insbesondere mittels I/U-Wandlern, Hochpass-Filtern, Tiefpass-Filtern und/oder Verstärkern die Ausgabe eines Analogsignals erzeugt wird.

Das erfindungsgemäße Verfahren ist von besonderem Vorteil, da es eine zeitlich hochaufgelöste elektrische Leistungs- und/oder Energiebestimmung ermöglicht. Insbesondere erfolgen die Messungen mit einer Abtastrate, welche mindestens eine Größenordnung über der Frequenz des Messsignals liegt. Durch die gleichzeitige Messung der beiden physikalischen Größen Strom und Spannung erfolgt auch die Ermittlung des Leistungs- bzw. Energiewert on board und simultan.

Die erfindungsgemäße Vorrichtung umfasst eine berührungslose Strommesseinrichtung und eine berührungslose Spannungsmesseinrichtung, wobei zumindest eine der berührungslosen Messeinrichtungen eine elektromagnetische Feldabschirmung aufweist, mit einer Messsignalverarbeitungseinrichtung, welche ausgestaltet ist, aus den gemessenen Strom- und Spannungswerten eine elektrische Leistung P = u·i und/oder Energie E = ∫ u·i dt zu ermitteln, und wobei wenigstens ein Abstandshalter, insbesondere eine Montagevorrichtung umfasst ist, mittels welchem die Vorrichtung an einem zu vermessenden elektrischen Leiter galvanisch getrennt zu diesem angeordnet werden kann. Die vorgeschlagene Lösung kombiniert zwei berührungslose Messverfahren. Diese Vorrichtung hat unter anderem den Vorteil eine präzise, zeitlich hochaufgelöste und gleichzeitige Bestimmung der beiden physikalischen Größen Strom und Spannung am selben Messpunkt oder Messabschnitt eines zu vermessenden elektrischen Leiters durchzuführen und daraus eine elektrische Leistung oder elektrische Energie zu ermitteln. Damit wird eine elektrische Anordnung präsentiert, welche die beiden Probleme der Netztrennung und der Sicherheitsanforderungen durch ein berührungsloses Verfahren löst.

Unter berührungsloser Messung ist eine indirekte Messung zu verstehen, welche kontaktlos, also potentialfrei, eine elektrische Spannung oder einen elektrischen Strom misst. Ein unter Spannung stehendes Messobjekt erzeugt ein elektrisches Feld. Dieses elektrische Feld kann berührungslos gemessen werden, beruhend auf einer Messung der zeitlichen Veränderung einer elektrischen Kapazität. Eine berührungslose Strommessung nutzt als physikalische Messgröße das durch bewegte Ladungen induzierte Magnetfeld. Mit Hilfe einer Rechenoperation die momentane Leistung P = u·i im stromdurchflossenen Leiter beziehungsweise den zeitlich integrierten Energiefluss E = ∫ u·i dt im stromdurchflossenen Leiter bestimmen. Bei einer berührungslosen Messung erfolgt keine elektrische Kontaktierung und kein Eingreifen in einen Stromkreis und daher keine Beschädigung einer Isolation, da eine galvanische Trennung vorliegt. Mittels der Abstandshalter können bestehende Systeme, z.B. sogenannte Brownfield-Systeme, ohne Eingriff sehr einfach nachgerüstet und somit auch einfach digitalisiert werden.

In einer besonders bevorzugten Ausgestaltung der Erfindung umfasst die berührungslose Spannungsmesseinrichtung einen Sensor zur Messung einer elektrischen Feldstärke. Insbesondere ist die Spannungsmesseinrichtung als MEMS-Voltmeter ausgestaltet. Dies birgt unter anderem den Vorteil, dass durch die MEMS-Voltmeter-Technologie sehr große Spannungsmessbereiche abgedeckt werden können, von einzelnen Volt bis zu vielen Kilovolt.

Das Prinzip des MEMS-Voltmeters basiert auf der periodischen Schirmung zweier Elektroden in einem externen elektrischen Feld. Bei konstanter Kapazität der Elektroden und gleichbleibendem Abstand zu einem externen Potential, kann so die Spannung berechnet werden. Bahrenyni et al., Analysis and Design of a Micromachined Electric-Field Sensor, Journal of Microelectromechanical Systems, Vol. 17, Nr. 1, Februar 2008, S. 31-36 etwa beschreibt, dass Elektrofeldmeter gängige Sensoren für elektrische Felder in den oben genannten Anwendungsfeldern. Das Funktionsprinzip basiert auf einem geerdeten Shutter, der wiederholt eine Sensorelektrodenanordnung von einem zu messenden Feld abschirmt und wieder dem Feld aussetzt. Entsprechend Gaußschem Gesetz, wir die Sensorelektrodenanordnung hinter dem Shutter durch Influenz des externen elektrischen Feldes abwechselnd ent- und aufgeladen (Verschiebestrom). Im vorliegenden Fall wird eine miniaturisierte Vorrichtung dazu vorgeschlagen.

In einer weiteren bevorzugten Ausgestaltung der Erfindung umfasst die Vorrichtung Strommesseinrichtung und Spannungsmesseinrichtung, welche in zwei getrennten Chip-Packages auf einem gemeinsamen Schaltungsträger angeordnet sind. In einer alternativen, ebenfalls vorteilhaften Ausgestaltung der Erfindung umfasst die Vorrichtung Strommesseinrichtung und Spannungsmesseinrichtung, welche auf zwei getrennten Sensorchips innerhalb eines gemeinsamen Chip-Packages angeordnet sind. Und in einer weiteren alternativen, ebenfalls vorteilhaften Ausgestaltung der Erfindung umfasst die Vorrichtung Strommesseinrichtung und Spannungsmesseinrichtung, welche auf einem gemeinsamen Sensorchip angeordnet sind, insbesondere als integrierte Elektronik. Dabei ist unter einem Schaltungsträger beispielsweise eine Leiterplatte oder eine alternative Basis für eine elektronische Baugruppe zu verstehen. Unter einem Sensorchip ist insbesondere ein Halbleitersubstrat, ein sogenannter Die oder Wafer zu verstehen, welcher im Gegensatz zum Chip-Package noch ungehäust, also nackt ist. Unter dem Chip-Package ist dann entsprechend ein ummantelter Halbleiterchip zu verstehen, wobei das Chipgehäuse dabei sowohl Schutz- als auch Montage- und Abstandshalter funktion übernehmen kann.

In allen Fällen werden beide Messungen, Strom- und Spannungsmessung, von einem Board aus gemessen. Bevorzugt befinden sich beide Messeinrichtungen in einem Abstand weniger Zentimeter voneinander, was als "selber Ort", "selber Messpunkt" oder "Messung am selben Leitungsabschnitt" verstanden wird. Die Strom- und Spannungsmessung derartig an einem Ort durchführen zu können wird insbesondere dadurch ermöglicht, dass mittels der elektromagnetische Feldabschirmung keine die Messung störende Feldbeeinflussung geschieht. Bevorzugt werden die Messungen auch auf selbigem Board ausgewertet. Alternativ werden mehrere Boards oder Schaltungsträger gestapelt.

In einer vorteilhaften Variante der Vorrichtung umfasst die berührungslose Strommesseinrichtung ein Hall-Element. Mittels eines Hall-Sensors können Gleich- sowie Wechselströme gemessen werden. Ein Hall-Element basiert auf der Messung der magnetischen Flussdichte. Bereits bei einem sehr kleinen Strom von um die 0.5 A und einem einfachen siliziumbasierten Hall-Sensor, kann eine gut messbare Hall-Spannung von 10 mV erreicht werden. Üblicherweise umfasst ein Hall-Element magnetische Fluss-Konzentratoren aus Eisen, sogenannte IMCs. Die Messung kann auch über sogenannte XMR-Sensoren erfolgen, bei welchen es zu einer Änderung des elektrischen Widerstands auf Grund des magnetischen Flusses kommt. XMR-Sensoren sind Sensoren für magnetische Flussdichten, insbesondere Dünnschicht-Sensoren, die unter Einfluss des magnetischen Flusses direkt ihren Widerstand ändern. Darunter fallen beispielsweise GMR-Sensoren, AMR-Sensor oder CMR-Sensoren.

Eine Alternative stellt die Rogowski-Spule zur berührungslosten Strommessung dar. Mit einer Rogowski Spule ist jedoch nur dir Messung von Wechselspannung möglich. Mittels Hall-Element ist diese Einschränkung nicht gegeben.

In einer weiteren vorteilhaften Variante der Vorrichtung ist die Messsignalverarbeitungseinrichtung ausgestaltet, die beiden Messignale, also Strom und Spannung, analog und / oder digital miteinander zu verrechnen. Sind Strom und Spannung bekannt, sind die Werte für Leistung P = U*I und Energy E= ∫ P dt einfache Rechenoperationen. Die digitale Auswertung hat den Vorteil, dass dann auch die einzelnen Werte noch digital Vorliegen.

In einer weiteren vorteilhaften Variante der Vorrichtung ist eine Signalvorverarbeitungseinrichtung auf Ebene der Sensoren, insbesondere einer der beiden Messvorrichtungen umfasst, z.B. I/U-Wandlern, Hochpass-Filtern, Tiefpass-Filtern und/oder Verstärkern, welche ein Analogsignal an die Messsignalverarbeitungseinrichtung ausgibt.

Bevorzugt umfasst die Vorrichtung beziehungsweise die Messsignalverarbeitungseinrichtung eine weitere Signalverarbeitungseinrichtung auf einem gemeinsamen Schaltungsträger oder einem gemeinsamen Schaltungsträgerstapel. Insbesondere ist die Vorrichtung beziehungsweise die Messsignalverarbeitungseinrichtung ausgestaltet, mittels des gemeinsamen Schaltungsträgers auf Systemebene zu kommunizieren. Beispielsweise weist die Vorrichtung einen Anschluss für eine Datenausgabe auf, einen Stecker, Datenanschluss oder anderes Interface, worüber insbesondere eine Kommunikation an eine Datenverarbeitungseinrichtung erfolgt, beispielsweise an einen Computer. Unter Computer können beispielsweise Personal Computer, Server, Handheld-Computer-Systeme, Pocket-PC-Geräte, Mobilfunkgeräte, Edge-Devices und andere Kommunikationsgeräte, die rechnergestützt Daten verarbeiten können, Prozessoren und andere elektronische Geräte zur Datenverarbeitung verstanden werden.

Zweckdienlicherweise weist die Vorrichtung, beziehungsweise die Messsignalverarbeitungseinrichtung ein BUS-System für die Zusammenführung der Messsignale auf, insbesondere bei der digitalen Leistung- und/oder Energiewertbestimmung. Alternativ weist die Messsignalverarbeitungseinrichtung eine Auswerteelektronik für analoge Auswertung auf.

### Figurenbeschreibung:

Weitere Merkmale, Eigenschaften und Vorteile der vorliegenden Erfindung ergeben sich aus der nachfolgenden Beschreibung unter Bezugnahme auf die beiliegende Figuren 1 bis 13. Darin zeigen:
- Fig.1: zeigt schematisch die Funktionsweise des MEMS-Voltmeters.
- Fig.2: zeigt schematisch das Messprinzip des Energiemeters.
- Fig.3: zeigt Messergebnisse eines MEMS-Voltmeters.
- Fig.4: zeigt eine Simulation eines stromdurchflossenen Leiters und einem Hall-Element.
- Fig.5: zeigt eine schematische Konstruktionszeichnung für ein MEMS-Voltmeter.
- Fig.6: zeigt schematisch das Messprinzip des Energiemeters mit elektromagnetische Feldabschirmung.
- Fig.7: zeigt schematisch den Aufbau des Energiemeters angeordnet mit einem Kabel.
- Fig.8: zeigt schematisch einen Querschnitt durch das Gehäuse des Energiemeters.
- Fig.9: zeigt schematisch den IMC des Hall-Elements als Kabelzange.
- Fig.10: zeigt schematisch das Messprinzip des Hall-Elements.
- Fig.11: zeigt schematisch den Querschnitt durch das Gehäuse des Energiemeters gemäß Fig. 9.
- Fig.12: zeigt schematisch einen isolierenden Abstandshalter ausgestaltet als Kabeldurchführung.
- Fig.13: zeigt eine Schaltungszeichnung einer anlogen Signal(vor)verarbeitungseinrichtung.
- Fig.14: zeigt schematisch einen Abstandshalter mit Abstandssensoren.

In den Ausführungsbeispielen und Figuren können gleiche oder gleich wirkende Elemente jeweils mit den gleichen Bezugszeichen versehen sein. Die dargestellten Elemente und deren Größenverhältnisse untereinander sind grundsätzlich nicht als maßstabsgerecht anzusehen, vielmehr können einzelne Elemente, zur besseren Darstellbarkeit und/oder zum besseren Verständnis im Verhältnis größer dimensioniert dargestellt sein.

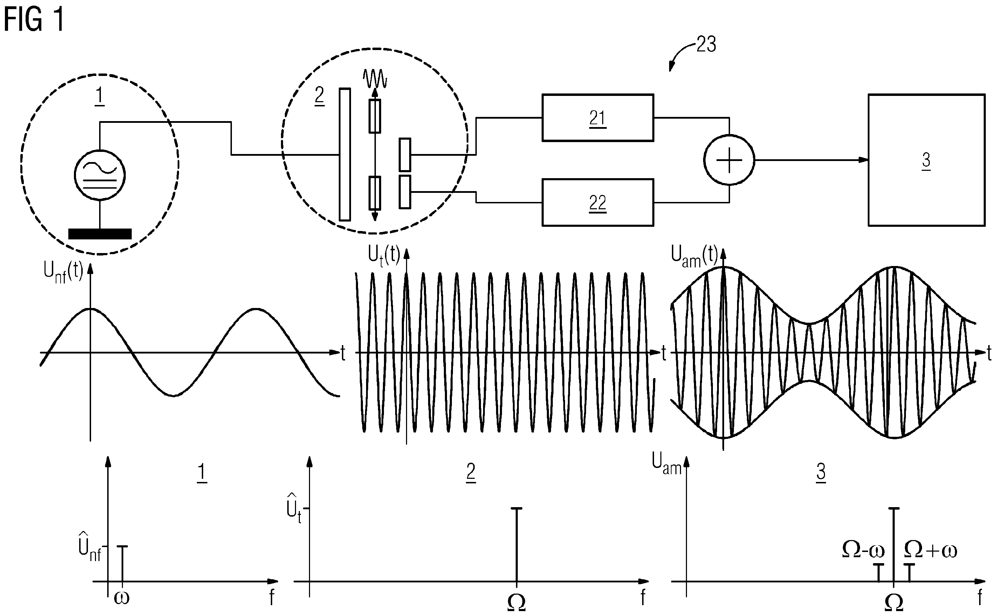

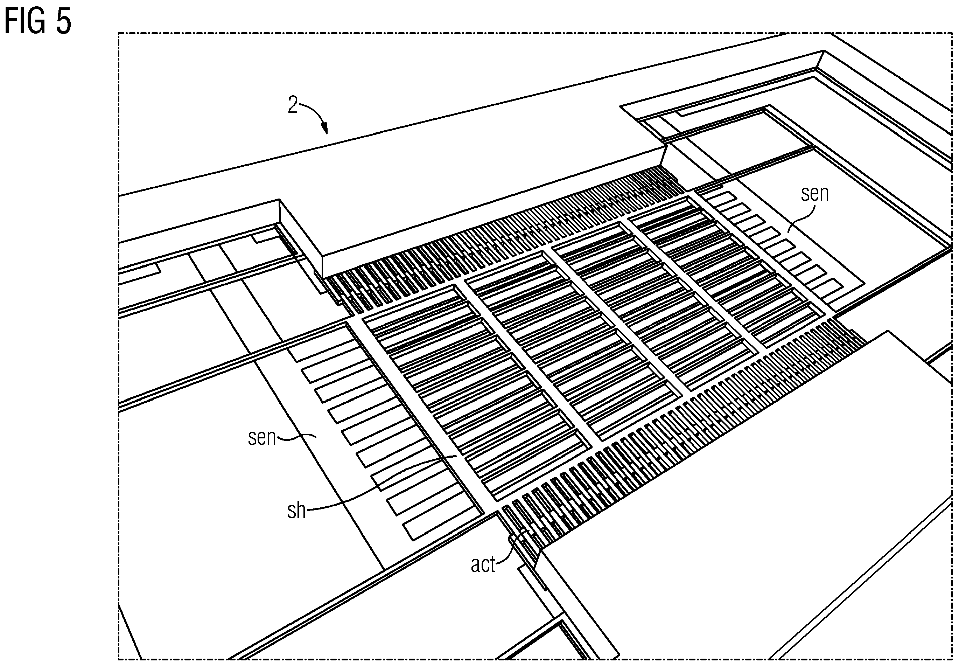

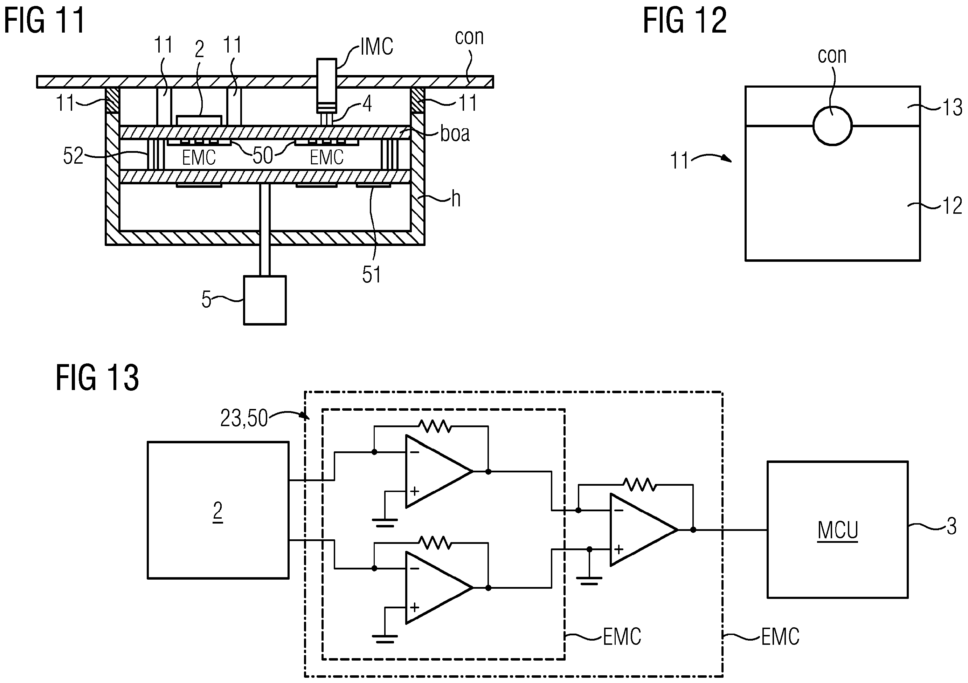

In Fig. 1 ist schematisch die Funktionsweise des MEMS-Voltmeters 2 dargestellt: Ein unter Spannung U stehendes Messobjekt 1 erzeugt ein elektrisches Feld E. Dieses elektrische Feld E wird mit Hilfe des MEMS-Voltmeters 2 berührungslos gemessen. Fig.5 zeigt eine schematische Konstruktionszeichnung für ein MEMS-Voltmeter 2. Es handelt sich um zwei elektrisch gegeneinander isolierte Kondensatorflächen sen, welche durch eine Verstärkerschaltung 23 miteinander verbunden sind, vgl. Fig. 13. Räumlich planparallel über diesen Kondensatorflächen sen, bzw. in Richtung der Quelle des zu messenden elektrischen Feldes E, ist eine schwingende Elektrode sh angeordnet, welche auf einem neutralen Bezugspotential liegt. Diese schwingende Elektrode sh schattet je nach Auslenkung eine der beiden Kondensatorflächen sen vom elektrischen Feld E des externen, zu vermessenden elektrischen Leiters con ab. Relativ zur Stärke des externen elektrischen Feldes E fließt ein Strom bei jedem Schwingungsdurchgang der Elektrode sh. Die Vorzeichen der Ströme beider Kondensatorflächen sind dabei stets gegensätzlich. Die Differenz dieser Stromflüsse ist proportional zum elektrischen Feld E des Leiters con und kann durch die Verstärkerschaltung 23 gemessen werden. Dieses elektrische Feld E wiederum ist von der elektrischen Spannung U des Leiters con und dem Abstand zum Leiter con definiert.

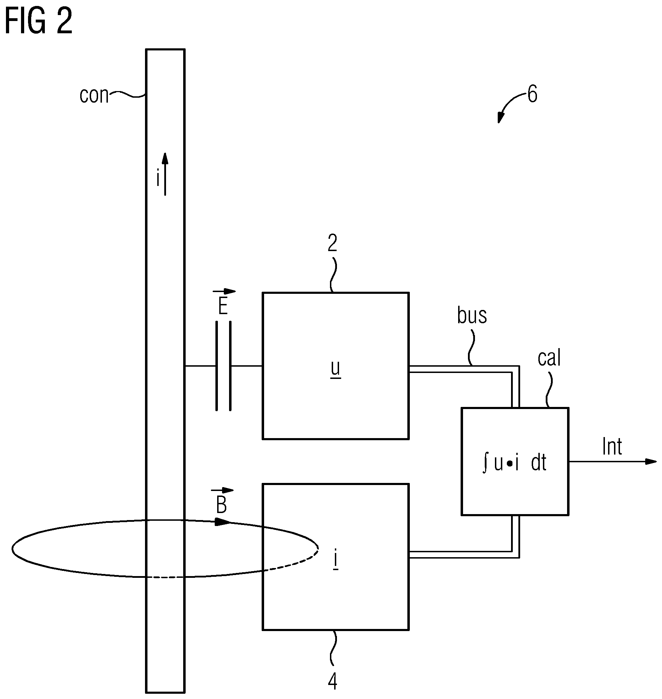

Kombiniert man diese Spannungsmessung 2 mit einer berührungslosen Strommessung 4, z.B. auf Basis eines Magnetfeldsensors, insbesondere eines Hall-Sensors oder einer Rogowski-Spule, so kann man mit Hilfe einer einfachen Rechenoperation cal die momentane Leistung P im Leiter con, beziehungsweise den zeitlich integrierten Energiefluss im Leiter con bestimmen. Die Strommessung 4 nutzt als physikalische Messgröße das durch bewegte Ladungen erzeugte Magnetfeld B. Das Messprinzip eines solchen Energiemeters 6 ist in Fig. 2 gezeigt: Durch die zeit- und ortsgleiche Bestimmung von Strom- und Spannungsverlauf kann durch eine einfache Multiplikation der beiden Werte der aktuelle Leistungsfluss u·i im Leiter con berechnet werden oder durch eine zeitliche Integration der Energiefluss ∫ u·i dt durch den Leiter con.

Die Anordnung der beiden Sensoren 2, 4 kann auf unterschiedliche Art und Weise erfolgen. So können das Voltmeter 2 und der Stromsensor 4 monolithisch auf einem einzelnen Halbleitersubstrat untergebracht werden. In einer weiteren Ausführungsform werden zwei getrennte Sensorchips 2, 4 innerhalb eines gemeinsamen Chip-Packages untergebracht. In einer dritten Ausführungsform werden zwei voneinander unabhängige Chip-Packages auf einem gemeinsamen Schaltungsträger boa verbunden.

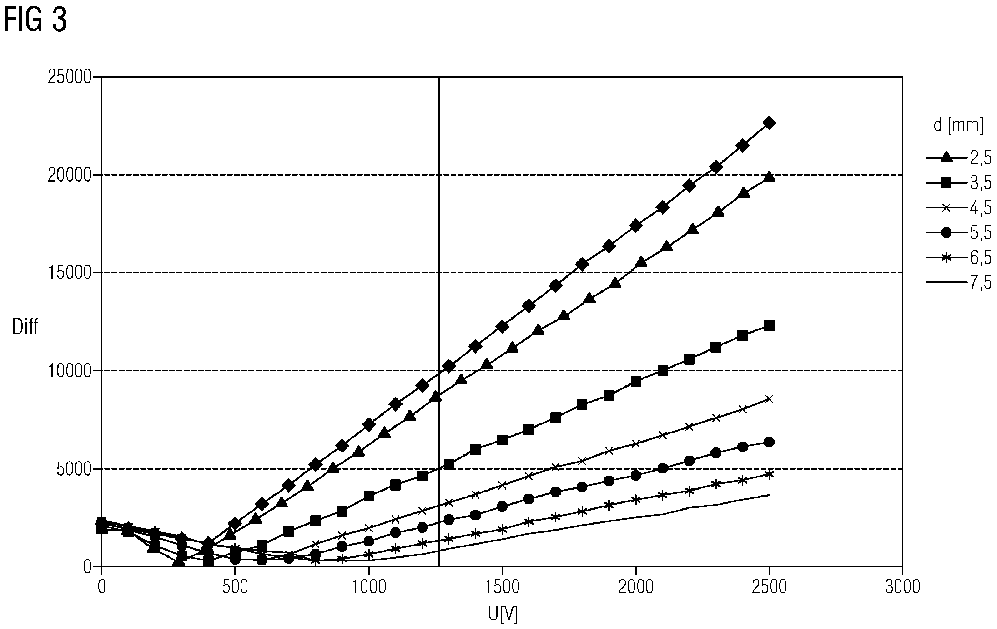

In Fig. 3 sind Messergebnisse eines MEMS-Voltmeters gezeigt, die Amplitudendifferenz Diff=Max-Min in ADC-Digits, in Abhängigkeit von gemessener Spannung U in Volt und Abstand d in mm des Sensors 2 zur Stromleitung con. Die Messwerte zeigen eine gute Linearität unabhängig vom Messabstand d. Gezeigt ist ein gutes Ansprechen des Sensors 2 bei unterschiedlichen Spannungen U und Abständen d des Sensors zur Messleitung con.

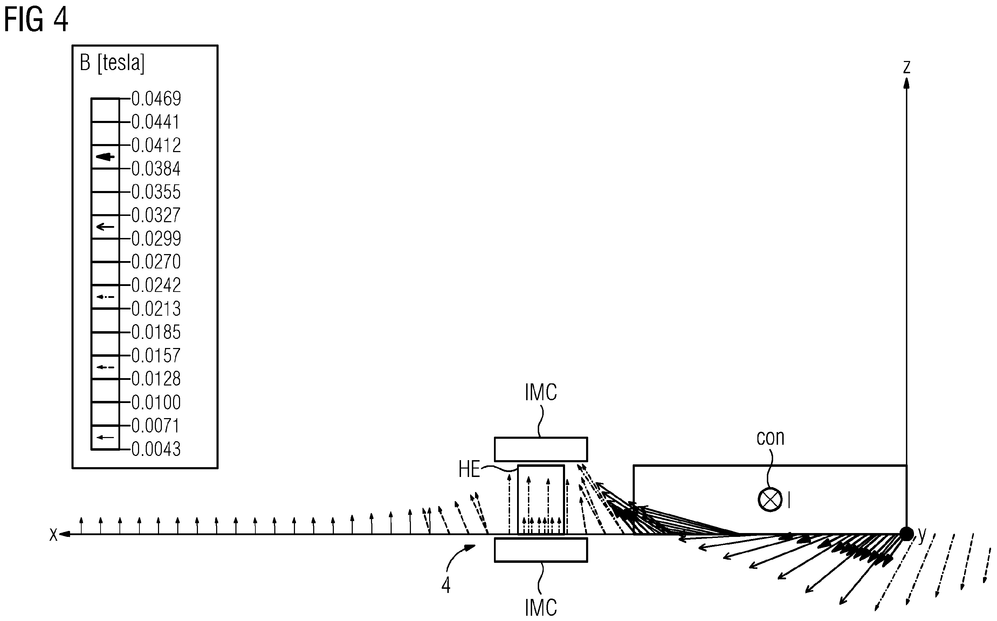

In Fig.4 ist eine Simulation eines stromdurchflossenen Leiters con und einem Hall-Element HE mit magnetischen Fluss-Konzentratoren IMC aus Eisen gezeigt. Die Pfeile zeigen die magnetische Feldstärke, beziehungsweise magnetische Flussdichte B in Tesla in den drei Raumrichtungen x, y, z an. Zum Vergleich: das Erdmagnetfeld in mitteleuropäischen Breiten weist eine magnetische Flussdichte B von 48µT auf. In einer Ausführungsform der erfindungsgemäßen Vorrichtung, beispielsweise ein Energiemeter 6, wird ein MEMS-Voltmeter 2 mit einem Hall-Sensor 4 gekoppelt. Die beiden Mess-Signale i, u werden analog und/oder digital miteinander verrechnet cal.

Bezüglich des MEMS-Voltmeter-Bauteils 2 ist in Fig. 5 eine schematische Konstruktionszeichnung eines MEMS-Chips 2 abgebildet. Mit einem solchen MEMS-Chip können beispielsweise Messergebnisse wie in Fig. 3 gezeigt erzielt werden.

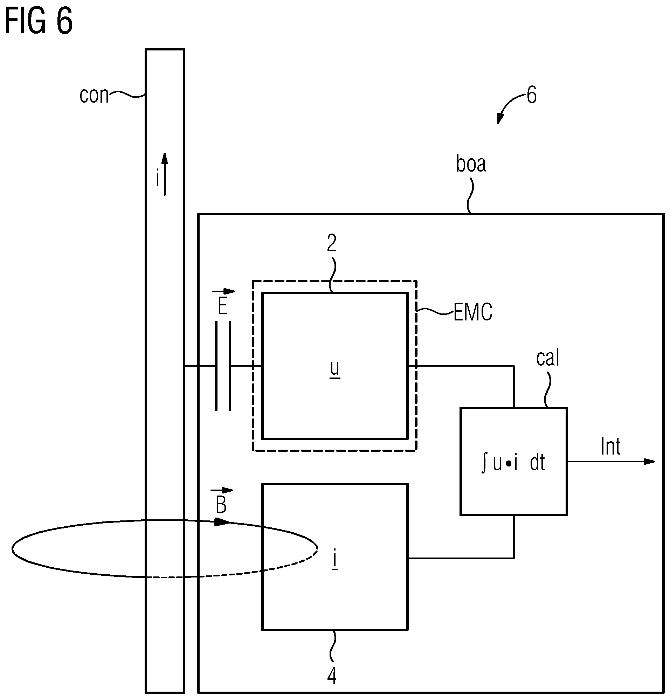

Fig.6 zeigt schematisch das Messprinzip des Energiemeters 6 mit einer elektromagnetischen Feldabschirmung EMC der Spannungsmessvorrichtung 2. Alternativ oder zusätzlich kann auch die Strommessvorrichtung 4 mit einer elektromagnetischen Feldabschirmung EMC umgeben sein. Alternativ oder zusätzlich weist in einer Ausführungsform des Energiemeters 6 die gesamte Einheit von Messvorrichtungen 2, 4 und Auswerteeinheit 23, cal eine elektromagnetische Feldabschirmung EMC auf.

Die Auswerteelektronik 23, cal kann dementsprechend auf unterschiedlichen Ebenen integriert sein. So kann z.B. eine gewisse Vorverarbeitung 23 der Signale auf Ebene der Sensoren 2, 4 durchgeführt werden, die finale Verarbeitung jedoch auf dem gemeinsamen Schaltungsträger boa. Mit Hilfe dieses Schaltungsträgers boa findet dann auch die Kommunikation auf Systemebene statt.

In einer alternativen Ausführungsform der Vorrichtung 6 ist auch die Erfassung der beiden Messgrößen u, i mit einer gewissen räumlichen Trennung aber am gleichen Leiter möglich. Die Zusammenführung der Messsignale erfolgt dann beispielsweise über ein Bus-System bus, wie in Fig.2 gezeigt. Die anschließende Verarbeitung cal erfolgt dann beispielsweise mittels einer angeschlossenen Auswerte-Elektronik oder digitalen Auswerteeinrichtung, z.B. einem Mikroprozessor.

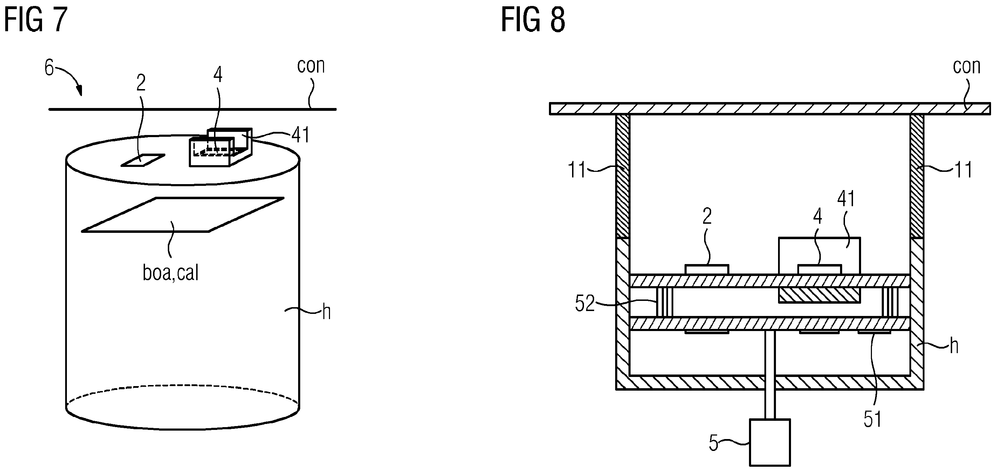

Fig.7 zeigt schematisch den Aufbau des Energiemeters 6 mit Sensorgehäuse h und innenliegender Elektronik boa, cal, angeordnet mit einem Kabel con. Fig.8 zeigt schematisch den Querschnitt durch das Gehäuse h des Energiemeters 6. Darin ist ein Schaltungsträgerstapel aus mehreren Boards boa gezeigt, die über Leiterplattenverbinder 52 verbunden sind. Des Weiteren ist ein Anschlusskabel oder Stecker 5 vorgesehen. Auf den Leiterplatten boa können weitere elektronische Komponenten 51 vorgesehen sein. Die Strommesseinrichtung 4 weist ein magnetisches Shielding 41 auf. Dieses umfasst insbesondere magnetische Flusskonzentratoren aus Eisen, sogenannte IMCs. Der u-förmige ausgestaltete Flusskonzentrator ist dabei jedoch um 90° gedreht zum Leiter con angeordnet.

Des Weiteren weist die Energiemeter-Vorrichtung 6 6 beispielsweise isolierende Abstandshalter 11 auf, welche insbesondere gleichzeitig zur Arretierung am zu vermessenden Leiter con dienen. Mittels der Abstandshalter 11 wird zum einen die galvanisch getrennte Anordnung realisiert, zum anderen wird ein Abstand d zwischen Sensoren 2, 4 und Feldquelle con einstellbar.

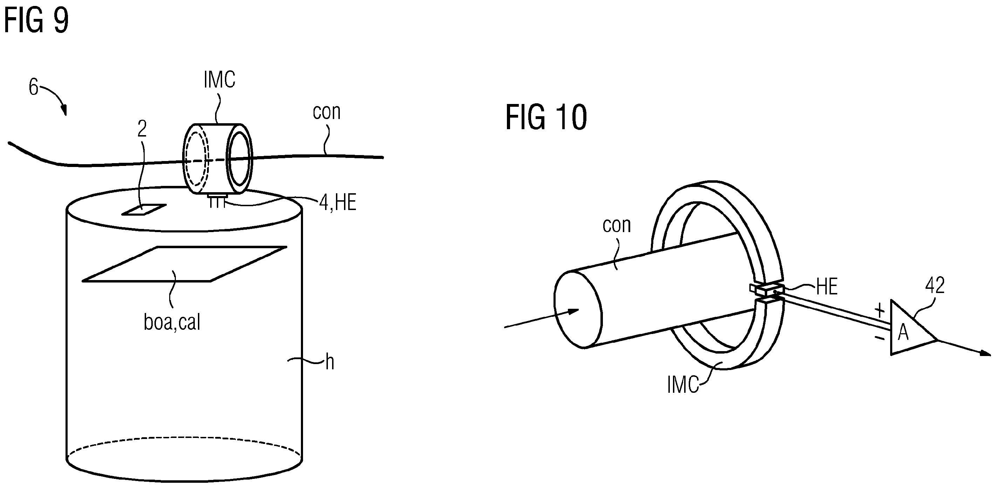

Fig.9 zeigt schematisch den Flusskonzentrator IMC des Hall-Elements HE als eine Art Kabelzange. Das dazugehörige Messprinzip des Hall-Elements HE ist in Fig.10 schematisch gezeigt. Das analoge Messsignal wird beispielsweise über einen Verstärker 42 ausgegeben. So ein Verstärker 42 kann beispielsweise eine analoge Messsignalvorverarbeitungseinrichtung darstellen oder darin enthalten sein.

Fig.11 zeigt schematisch den Querschnitt durch das Gehäuse h des Energiemeters 6 gemäß Fig. 9. Darin ist wieder ein Schaltungsträgerstapel aus mehreren Boards boa gezeigt, die über Leiterplattenverbinder 52 verbunden sind. Des Weiteren ist ein Anschlusskabel oder Stecker 5 vorgesehen. Auf den Leiterplatten boa sind analoge Schaltungen mit jeweils EMC Shieldings 50 vorgesehen. Diese können beispielsweise die analogen Messsignalvorverarbeitungseinrichtungen von jeweils Strom- und Spannungsmessvorrichtung sein. Die Strommesseinrichtung 4 weist einen kreisförmigen Flusskonzentrator IMC auf, der um das zu vermessende Kabel con angeordnet ist. Der Spannungssensor 2 weist ein elektromagnetisches Shielding EMC auf, welches insbesondere auch die beiden Sensoren 2, 4 voreinander abschirmt. Beim Spannungssensor 2 ist vor allem die Abschirmung EMC, 50 der Auswerteelektronik wichtig. Der Sensor 2 selbst muss aber gegenüber dem Leiter con exponiert bleiben. Vorteilhaft ist es, wenn diese Auswerteelektronik auf der dem zu messenden Leiter con abgewandten Seite des Boards boa liegt, wie auch in Figur 11 dargestellt.

Fig.12 zeigt schematisch eine mögliche Auführungsform eines isolierenden Abstandshalters 11, welcher als Kabeldurchführung ausgestaltet ist. Dieser Abstandshalter 11 umfasst ein einen isolierenden Abstandshalter als Unterteil 12 und Befestigung an der Energiemeter-Vorrichtung 6 sowie ein steck- oder klippbares Oberteil 13, mittels welchem das zu vermessende Kabel con fixiert werden kann. Diese Kabeldurchführung sorgt entsprechend für eine galvanisch getrennte Anordnung.

Ein besonderes Augenmerk ist auch auf die Beeinflussung der Messung durch Störfelder zu richten. Soll z.B. in einem Mehr-Phasensystem gemessen werden, ist dafür Sorge zu tragen, dass die nicht-zu-messenden Phasen durch eine geeignete leitfähige Schirmung EMC abgeschirmt werden und/oder der Abstand d des Sensors 2 von dem zu messenden Leiter con wesentlich kleiner ist, als der Abstand d zwischen dem Leiter con und einem störenden Feld, z.B. bewirkt durch einen weiteren Leiter. Daher ist die Vorrichtung 6 bevorzugt auch so ausgestaltet, dass Zuleitungen, wie Messleitungen und/oder Versorgungsleitungen des Sensors 2 von externen elektrischen Feldern abgeschirmt werden, um Störeinkopplungen zu vermeiden. Zusätzlich dazu ist die Anordnung der Versorgungsleitungen, z.B. für die hochfrequente Anregung der schwingenden Elektrode sh sowie die Messleitungen zueinander geeignet zu wählen, um ein Übersprechen der Hochfrequenzanregung in die sensiblen Messkanäle zu vermeiden.

Fig.13 zeigt eine Schaltungszeichnung einer anlogen Signal(vor)verarbeitungseinrichtung 23, 50. In diesem Schaltbild ist stark simplifiziert gezeigt, wie die Voltmeter-Parts abgeschirmt werden können. Beispielsweise werden Teile der analogen Schaltung 23, 50 zur Verstärkung beider Sensorpfade abgeschirmt oder sogar noch weiter inklusive des Differenzverstärkers, welcher das Analogsignal 3 ausgibt. Das eigentlich MEMS-Bauteil, wie in Fig.5 gezeigt, ist beispielsweise auf der Rückseite der Schirmung EMC beziehungsweise des PCBs angeordnet, vgl. Querschnitt in Fig 11. Auch der Hall-Sensor könnte zusätzlich vergleichbar geschirmt werden. Bevorzugt ist aber zumindest das Voltmeter geschirmt.

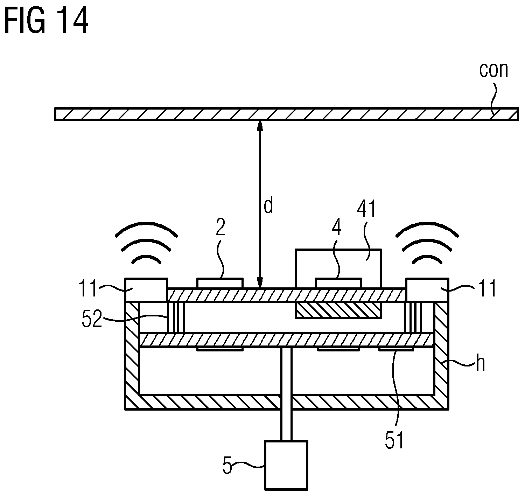

In Fig.14 werden schematisch Abstandshalter 11 mit Abstandssensoren gezeigt. Diese sind besonders vorteilhaft beim Einsatz zur Messung von Freilandleitungen und Erdkabeln, da keine bauliche Verbindung zum zu messenden Leiter con erforderlich ist. Bei genau bekanntem Abstand könnte auch ohne Sensoren gearbeitet werden.

Obwohl die Erfindung im Detail durch die bevorzugten Ausführungsbeispiele näher illustriert und beschrieben wurde, ist die Erfindung nicht durch die offenbarten Beispiele eingeschränkt. Variationen hiervon können vom Fachmann abgeleitet werden, ohne den Schutzumfang der Erfindung, wie er durch die nachfolgenden Patentansprüche definiert wird, zu verlassen.

### Bezugszeichenliste

- 1: Messspannung
- 2: MEMS-Voltmeter, Messvorrichtung
- sen: Sensorflächen
- sh: Shutter, beweglich
- act: Comb Aktuator
- 21: I/U-Wandler
- 22: I/U-Wandler
- 3: Analogsignal, Signalausgabe des Spannungssensors
- 4: Stromsensor, z.B. Hallelement HE
- bus: Datenbus
- cal: Rechner, Auswerteeinheit
- Int: Ergebnisausgabe: z.B. Energiefluss
- h: Sensorgehäuse mit innenliegender Elektronik (boa, cal)
- 5: Anschlusskabel, Stecker
- 51: weitere elektronische Komponenten
- 52: Leiterplattenverbinder
- 41: Magnetisches Shielding, Flusskonzentratoren (IMC) (90° gedreht zum Leiter con)
- 11: Abstandshalter
- 12: isolierender Abstandshalter als Kabeldurchführung ausgestaltet
- 13: steck- oder klippbares Oberteil
- Unf(t): modulierendes Nutzsignal
- Ut(t): unmodulierter Träger
- Uam(t): modulierter Träger
- U: Spannung
- t: Zeit
- f: Frequenz
- ω: Niederfrequenz
- Ω: Trägerfrequenz
- con: Elektrischer Leiter, z.B. Kabel
- i: elektrischer Stromfluss mit Richtungspfeil
- I: elektrischer Strom
- E: Elektrische Feldstärke
- B [tesla]: Magnetische Flussdichte des Magnetfeldes, von elektrischem Stromfluss i induziert
- d [mm]: Abstand Spg. zu Sensor LP
- Diff: SENSE-Diff-Amplitude [Max-Min] in ADC-Digits
- x,y,z: Raumrichtungen
- HE: Hall-Element
- IMC: Magnetische Flusskonzentratoren, z.B. IMCs aus Eisen
- boa: Schaltungsträger, z.B. Leiterplatte
- 42: Verstärker, Amplifier
- 50: analoge Schaltung mit EMC Shielding
- 23: analoge Signal(vor)verarbeitungseinrichtung
- EMC: elektromagnetische Abschirmung

## Patentansprüche

1. Verfahren zur berührungslosen elektrischen Leistungs- und/oder Energiebestimmung, bei dem in einem Messsignalverarbeitungsschritt (cal) aus gemessenen Strom- (i) und Spannungswerten (u) die elektrische Leistung (u·i) und/oder Energie (∫ u·i dt) ermittelt wird, wobei
- eine Vorrichtung (6) mit einem zu vermessenden elektrischen Leiter (con) galvanisch getrennt angeordnet wird,
- eine Strommessung (i(t)) an dem elektrischen Leiter (con) vorgenommen wird, indem das vom stromdurchflossenen Leiter (con, i) ausgehende magnetische Feld (B) mittels eines ersten Sensors (4) bestimmt wird,
- eine Spannungsmessung (u(t)) mittels eines MEMS-Voltmeters (2) an dem elektrischen Leiter (con) vorgenommen wird, indem das vom stromdurchflossenen Leiter (con, i) ausgehende elektrische Feld (E) mittels eines zweiten Sensors (2) bestimmt wird, indem mittels eines geerdeten Shutters, wiederholt eine Sensorelektrodenanordnung von dem zu messenden Feld (E) abgeschirmt und wieder dem Feld (E) ausgesetzt wird, so dass die Sensorelektrodenanordnung hinter dem Shutter durch Influenz des zu messenden elektrischen Feldes (E) abwechselnd ent- und aufgeladen wird,
und die beiden Messsignale (i, u) analog mittels eines elektrischen Schaltkreises und / oder in einem digitalen Datenverarbeitungsschritt (cal) miteinander verrechnet werden.

2. Verfahren nach Anspruch 1, bei dem die Vorrichtung (6) mittels Abstandshaltern (11) in einem vorgebbaren Messabstand relativ zum zu vermessenden elektrischen Leiter (con) galvanisch getrennt angeordnet wird.

3. Verfahren nach einem der vorstehenden Ansprüche 1 oder 2, umfassend mindestens einen analogen Messsignalvorverarbeitungsschritt (23) auf Ebene der Sensoren (2, 4), insbesondere mittels I/U-Wandlern (21), Hochpass-Filtern, Tiefpass-Filtern und/oder Verstärkern und Ausgabe eines Analogsignals.

4. Vorrichtung (6) umfassend eine berührungslose Strommesseinrichtung (4) und eine berührungslose Spannungsmesseinrichtung (2), wobei die berührungslose Spannungsmesseinrichtung (2) eine Sensorelektrodenanordnung und einen geerdeten Shutter (sh) umfasst, welcher Shutter (sh) zudem ausgestaltet ist, wiederholt die Sensorelektrodenanordnung von dem zu messenden Feld (E) abzuschirmen und wieder dem Feld (E) auszusetzen, insbesondere umfasst die Sensorelektrodenanordnung zwei elektrisch gegeneinander isolierte Kondensatorflächen (sen), welche durch eine Verstärkerschaltung (23) miteinander verbunden sind, und insbesondere ist räumlich planparallel über diesen Kondensatorflächen (sen), bevorzugt in Richtung der Quelle des zu messenden elektrischen Feldes (E), eine schwingende Elektrode als Shutter (sh) angeordnet, welche auf einem neutralen Bezugspotential liegt und welche, je nach Auslenkung, eine der beiden Kondensatorflächen (sen) vom zu messenden elektrischen Feld (E) abschirmt, und wobei zumindest eine der berührungslosen Messeinrichtungen eine elektromagnetische Feldabschirmung (EMC) aufweist, mit einer Messsignalverarbeitungseinrichtung (cal), welche ausgestaltet ist, aus den gemessenen Strom- (i) und Spannungswerten (u) eine elektrische Leistung (u·i) und/oder Energie (∫ u·i dt) zu ermitteln, und wobei wenigstens ein Abstandshalter (11) umfasst ist, mittels welchem die Vorrichtung (6) an einem zu vermessenden elektrischen Leiter (con) galvanisch getrennt zu diesem angeordnet werden kann.

5. Vorrichtung (6) nach Anspruch 4, wobei Strommesseinrichtung (4) und Spannungsmesseinrichtung (2) in zwei getrennten Chip-Packages auf einem gemeinsamen Schaltungsträger (boa) angeordnet sind.

6. Vorrichtung (6) nach Anspruch 4, wobei Strommesseinrichtung (4) und Spannungsmesseinrichtung (2) auf zwei getrennten Sensorchips innerhalb eines gemeinsamen Chip-Packages angeordnet sind.

7. Vorrichtung (6) nach Anspruch 4, wobei Strommesseinrichtung (4) und Spannungsmesseinrichtung (2) auf einem gemeinsamen Sensorchip angeordnet sind.

8. Vorrichtung (6) nach einem der Ansprüche 4 bis 7, wobei die berührungslose Strommesseinrichtung (4) ein Hall-Element (HE) oder einen XMR-Sensor umfasst.

9. Vorrichtung (6) nach einem der Ansprüche 4 bis 8, wobei die Messsignalverarbeitungseinrichtung (cal) ausgestaltet ist, die beiden Messignale (u, i) analog und / oder digital miteinander zu verrechnen.

10. Vorrichtung (6) nach einem der Ansprüche 4 bis 9, umfassend eine Signalvorverarbeitungseinrichtung (23) auf Ebene der Sensoren (2, 4), welche Signalvorverarbeitungseinrichtung (23) insbesondere als Verstärkerschaltung, zur Messung der Differenz der Stromflüsse, welche bei jedem Schwingungsdurchgang der Elektrode (sh) die Kondensatorflächen (sen) ent- und aufladen, ausgeführt ist.

11. Vorrichtung (6) nach einem der Ansprüche 4 bis 10, wobei die Messsignalverarbeitungseinrichtung (cal) eine weitere Signalverarbeitungseinrichtung auf dem gemeinsamen Schaltungsträger (boa) oder einem gemeinsamen Schaltungsträgerstapel umfasst.

12. Vorrichtung (6) nach Anspruch 11, wobei die Messsignalverarbeitungseinrichtung (cal) ausgestaltet ist mittels des gemeinsamen Schaltungsträgers (boa) auf Systemebene zu kommunizieren.

13. Vorrichtung (6) nach einem der Ansprüche 4 bis 12, wobei die Messsignalverarbeitungseinrichtung (cal) ein BUS-System (bus) für die Zusammenführung der Messsignale (u, i) sowie einen Anschluss (5) für die Datenausgabe (Int) aufweist.

## Claims

1. Method for non-contact electric power and/or energy determination in which electric power (u·i) and/or energy (∫ u·i dt) is ascertained from measured current (i) and voltage values (u) in a measurement signal processing step (cal), wherein
- a device (6) with an electric conductor (con) to be measured is arranged in a galvanically isolated manner,
- a current measurement (i(t)) is performed on the electric conductor (con) by determining the magnetic field (B) emanating from the current-carrying conductor (con, i) by means of a first sensor (4),
- a voltage measurement (u(t)) is performed on the electric conductor (con) by means of the MEMS voltmeter (2) by determining the electric field (E) emanating from the current-carrying conductor (con, i) by means of a second sensor (2), by a sensor electrode arrangement being repeatedly shielded from the field (E) to be measured and exposed to the field (E) again by means of a grounded shutter, so that the sensor electrode arrangement behind the shutter is alternately discharged and charged by the influence of the electric field (E) to be measured,
and the two measurement signals (i, u) are offset against one another by means of an electric circuit and/or in a digital data processing step (cal).

2. Method according to claim 1, in which the device (6) is arranged in a galvanically isolated manner by means of spacers (11) at a predeterminable measuring distance relative to the electric conductor (con) to be measured.

3. Method according to one of the preceding claims 1 or 2, comprising at least one analogue measurement signal preprocessing step (23) at the level of the sensors (2, 4), in particular by means of I/U converters (21), high-pass filters, low-pass filters and/or amplifiers and outputting an analogue signal.

4. Device (6) comprising a non-contact current measurement apparatus (4) and a non-contact voltage measurement apparatus (2), wherein the non-contact voltage measurement apparatus (2) comprises a sensor electrode arrangement and a grounded shutter (sh), which shutter (sh) is also embodied to repeatedly shield the sensor electrode arrangement from the field (E) to be measured and to expose it to the field (E) again, in particular the sensor electrode arrangement comprises two capacitor plates (sen) which are electrically isolated from one another and which are interconnected by an amplifier circuit (23), and in particular an oscillating electrode is arranged spatially plane-parallel above these capacitor plates (sen) as a shutter (sh), preferably along the direction of the source of the electric field (E) to be measured, which is at a neutral reference potential and which, depending on the deflection, shields one of the two capacitor plates (sen) from the electric field (E) to be measured, and wherein at least one of the non-contact measurement apparatuses has electromagnetic field shielding (EMC) with a measurement signal processing apparatus (cal), which is embodied to ascertain an electric power (u·i) and/or energy (∫ u·i dt) from the measured current (i) and voltage values (u), and wherein it comprises at least one spacer (11) by means of which the device (6) can be arranged on an electric conductor (con) to be measured in a galvanically isolated manner therefrom.

5. Device (6) according to claim 4, wherein the current measurement apparatus (4) and voltage measurement apparatus (2) are arranged in two separate chip packages on a common circuit carrier (boa).

6. Device (6) according to claim 4, wherein the current measurement apparatus (4) and voltage measurement apparatus (2) are arranged on two separate sensor chips within a common chip package.

7. Device (6) according to claim 4, wherein the current measurement apparatus (4) and voltage measurement apparatus (2) are arranged on a common sensor chip.

8. Device (6) according to one of claims 4 to 7, wherein the non-contact current measurement apparatus (4) comprises a Hall element (HE) or an XMR sensor.

9. Device (6) according to one of claims 4 to 8, wherein the measurement signal processing apparatus (cal) is embodied to offset the two measurement signals (u, i) against one another in an analogue and/or digital manner.

10. Device (6) according to one of claims 4 to 9, comprising a signal preprocessing apparatus (23) at the level of the sensors (2, 4), which signal preprocessing apparatus (23) is in particular embodied as an amplifier circuit, for measuring the difference in the current flows which discharge and charge the capacitor plates (sen) during each oscillation passage of the electrode (sh).

11. Device (6) according to one of claims 4 to 10, wherein the measurement signal processing apparatus (cal) comprises a further signal processing apparatus on the common circuit carrier (boa) or a common circuit carrier stack.

12. Device (6) according to claim 11, wherein the measurement signal processing apparatus (cal) is embodied to communicate at system level by means of the common circuit carrier (boa).

13. Device (6) according to one of claims 4 to 12, wherein the measurement signal processing apparatus (cal) has a BUS system (bus) for combining the measurement signals (u, i) and a connection (5) for data output (Int).

## Revendications

1. Procédé de détermination sans contact d'une puissance et/ou d'une énergie électrique, dans lequel dans un stade (cal) de traitement d'un signal de mesure, on détermine la puissance (u·i) électrique et/ou une énergie (∫ u·i dt) électrique à partir des valeurs mesurées de courant (i) et de tension (u), dans lequel
- on dispose de manière séparée galvaniquement un montage (6) ayant un conducteur (con) électrique à mesurer,
- on effectue une mesure (i(t)) du courant pour le conducteur (con) électrique en déterminant au moyen d'un premier capteur (4) le champ (B) magnétique provenant du conducteur (con, i) parcouru par le courant,
- on effectue, au moyen d'un voltmètre (2) MEMS, une mesure (u(t)) de tension sur le conducteur (con) électrique, en déterminant, au moyen d'un deuxième capteur (2) le champ (E) électrique, provenant du conducteur (con, i) parcouru par le courant, en protégeant de manière répétée, au moyen d'un shutter mis à la terre, un agencement d'électrodes de capteur du champ (E) à mesurer et en le resoumettant au champ (E), de manière à décharger et à charger en alternance l'agencement d'électrodes de capteur derrière le shutter par influence du champ (E) électrique à mesurer,
et on compense entre eux les deux signaux (i, u) de mesure d'une manière analogique au moyen d'un circuit électrique et/ou dans un stade (cal) de traitement de données numériques.

2. Procédé suivant la revendication 1, dans lequel on met le montage (6) de manière séparée galvaniquement du conducteur (con) électrique à mesurer à une distance pouvant être donnée à l'avance, au moyen d'écarteurs (11).

3. Procédé suivant l'une des revendications 1 ou 2 précédentes, comprenant au moins un stade (23) de traitement de signal de mesure analogique sur le plan des capteurs (2, 4), en particulier au moyen de convertisseurs (21) I/U, de filtres passe-haut, de filtres passe-bas et/ou d'amplificateurs et émission d'un signal analogique.

4. Montage (6) comprenant un dispositif (4) de mesure du courant sans contact et un dispositif (2) de mesure de la tension sans contact, dans lequel le dispositif (2) de mesure de la tension sans contact comprend un agencement d'électrodes de capteur et un shutter (sh) mis à la terre, lequel shutter (sh) est conformé en outre pour protéger de manière répétée l'agencement d'électrodes de capteur du champ (E) à mesurer et pour le resoumettre au champ (E), en particulier l'agencement d'électrodes de capteur comprend deux surfaces (sen) de condensateur isolées électriquement l'une de l'autre, lesquelles sont connectées l'une à l'autre par un circuit (23) amplificateur, et en particulier il est disposé dans l'espace parallèle à un plan au-dessus de ces surfaces (sen) de condensateur, de préférence en direction de la source du champ (E) électrique à mesurer, une électrode oscillante comme shutter (sh), qui est à un potentiel de référence neutre et qui, suivant la déviation, protège l'une des deux surfaces (sen) de condensateur du champ (E) électrique à mesurer,
et dans lequel au moins
l'un des dispositifs de mesure sans contact a un blindage (EMC) électromagnétique de champ, comprenant un dispositif (cal) de traitement du signal de mesure, qui est conformé pour déterminer une puissance (u·i) électrique et/ou une énergie (∫ u·i dt) à partir des valeurs mesurées de courant (i) et de tension (u), et dans lequel il comprend au moins un écarteur (11), au moyen duquel le montage (6) peut être monté sur un conducteur (con) électrique à mesurer en en étant séparé galvaniquement.

5. Montage (6) suivant la revendication 4, dans lequel le dispositif (4) de mesure du courant et le dispositif (2) de mesure de la tension sont disposés dans deux boîtiers de puces distincts sur un support (boa) de circuit commun.

6. Montage (6) suivant la revendication 4, dans lequel le dispositif (4) de mesure du courant et le dispositif (2) de mesure de la tension sont disposés sur deux puces séparées de capteur dans un boîtier de puces commun.

7. Montage (6) suivant la revendication 4, dans lequel le dispositif (4) de mesure du courant et le dispositif (2) de mesure de la tension sont disposés sur une puce de capteur commune.

8. Montage (6) suivant l'une des revendications 4 à 7, dans lequel le dispositif (4) de mesure du courant sans contact comprend un élément (HE) de Hall ou un capteur XMR.

9. Montage (6) suivant l'une des revendications 4 à 8, dans lequel le dispositif (cal) de traitement du signal de mesure est conformé pour comparer les deux signaux (u, i) de mesure entre eux, de manière analogique et/ou numérique.

10. Montage (6) suivant l'une des revendications 4 à 9, comprenant un dispositif (23) de prétraitement du signal sur le plan des capteurs (2, 4), lequel dispositif (23) de prétraitement du signal est réalisé en particulier sous la forme d'un circuit amplificateur pour la mesure de la différence des flux de courant, qui, à chaque passage oscillant de l'électrode (sh), décharge et charge les surfaces (sen) de condensateur.

11. Montage (6) suivant l'une des revendications 4 à 10, dans lequel le dispositif (cal) de traitement du signal de mesure comprend un autre dispositif de traitement du signal sur le support (boa) de circuit commun ou sur un empilement commun de support de circuit.

12. Montage (6) suivant la revendication 11, dans lequel le dispositif (cal) de traitement du signal de mesure est conformé pour communiquer, au moyen du support (boa) de circuit commun, sur le plan de système.

13. Montage (6) suivant l'une des revendications 4 à 12, dans lequel le dispositif (cal) de traitement du signal de mesure a un système BUS (bus) pour la réunion des signaux (u, i) de mesure ainsi qu'une connexion (5) pour la sortie (Int) de données.
